(19) Europäisches Patentamt
European Patent Office
Office européen des brevets

(11) Numéro de publication : **0 021 909**
**B1**

(12) **FASCICULE DE BREVET EUROPÉEN**

(45) Date de publication du fascicule du brevet : **07.08.85**

(51) Int. Cl.⁴ : **H 03 B 9/14**, H 03 F 7/04

(21) Numéro de dépôt : **80400787.0**

(22) Date de dépôt : **03.06.80**

(54) **Oscillateur pour hyperfréquences, stabilisé, à conversion de fréquence, et sa réalisation à l'état solide.**

(30) Priorité : **15.06.79 FR 7915452**

(43) Date de publication de la demande :
**07.01.81 Bulletin 81/01**

(45) Mention de la délivrance du brevet :
**07.08.85 Bulletin 85/32**

(84) Etats contractants désignés :
**DE GB NL**

(56) Documents cités :
**FR-A- 2 349 996**
**IEEE TRANSACTIONS ON MICROWAVE THEORY AND TECHNIQUES, vol. 24, no. 3, mars 1976 New York US NANBU: "A stabilized MIC oscillator using a germanium avalanche diode" pages 151-153**
**1974 IEEE INTERNATIONAL SOLID-STATE CIRCUITS CONFERENCE, 15 février 1974, New York US SATOH et al.: "Stabilized oscillator using a temperature-stable dielectric resonator", pages 184-185**
**IEEE TRANSACTIONS ON MICROWAVE THEORY AND TECHNIQUES, vol. MTT-19, no. 5, mai 1971 New York US OKEAN et al.: "Integrated parametric amplifier module with self-contained solid-state pump source" pages 491-493**

(73) Titulaire : **THOMSON-CSF**
**173, Boulevard Haussmann**
**F-75379 Paris Cedex 08 (FR)**

(72) Inventeur : **Kantorowicz, Gérard**
**"THOMSON-CSF" - SCPI 173, bld Haussmann**
**F-75360 Paris Cedex 08 (FR)**

(74) Mandataire : **Mayeux, Michèle et al**
**THOMSON-CSF SCPI 173, Bld Haussmann**
**F-75379 Paris Cedex 08 (FR)**

**EP 0 021 909 B1**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

L'invention concerne un oscillateur stabilisé pour ondes radioélectriques dans le domaine des hyperfréquences.

L'oscillateur de l'invention présente une structure générale qui rappelle celle des amplificateurs paramétriques. Il permet l'obtention d'une onde haute fréquence stabilisée sur une fréquence $f_o$.

Les amplificateurs paramétriques comprennent trois parties essentielles, correspondant à trois fréquences $f_s$, $f_p$ et $f_o$ qui coopèrent entre elles comme il va être rappelé.

Une première source de fréquence $f_s$ est assistée par une seconde source à la fréquence de pompe $f_p$, placée en parallèle avec elle aux bornes d'une capacité non linéaire, ou paramétrique, dont la valeur C(V) varie avec la tension appliquée à ses bornes. La capacité C(V) se comporte comme une résistance négative pour le signal de fréquence $f_s$, qui se trouve amplifié, en même temps qu'apparaît, dans une troisième dérivation, aux bornes de la capacité, un signal à la fréquence $f_o$, égale à la différence des deux fréquences $f_p$ et $f_s$ ; on a $f_o = f_p - f_s$.

La fréquence $f_p$, ou fréquence de pompe, est en général très supérieure à la fréquence $f_s$ du signal, et le niveau de puissance à cette fréquence $f_p$ très supérieur à celui du signal sur $f_s$. La source à la fréquence de pompe $f_p$ modifie l'impédance à la fréquence $f_s$ et permet l'amplification sur cette fréquence.

La fréquence $f_o$ est elle-même très supérieure à la fréquence $f_s$.

La même disposition est utilisée dans l'invention dans un autre but, celui de stabiliser une fréquence d'oscillation. La fréquence stabilisée dans le dispositif de l'invention est la fréquence $f_o$. On ne reviendra pas davantage ici sur la théorie des amplificateurs paramétriques pour laquelle on pourra se reporter à l'ouvrage de W. H. Louisell — Coupled Mode and Parametric Electronics — Wiley and Sons — N.Y. 1960.

On fera simplement remarquer que dans le cas de l'invention, cette disposition permet d'employer à la stabilisation de la fréquence $f_o$ des éléments résonnant à une fréquence $f_s$ sensiblement plus faible et capables, de ce fait, d'un meilleur coefficient de qualité. La fréquence $f_o$ est obtenue par transposition, ou conversion, de fréquence avec un rapport bruit/signal très voisin de celui qu'on obtiendrait à une fréquence stabilisée directement par le circuit à fort coefficient de qualité.

Par le document FR-A-2.349.996, on connaît un oscillateur pour hyperfréquences stabilisé à conversion de fréquence comprenant trois branches montées en parallèle sur une réactance non linéaire C(V) dont la valeur dépend de la tension appliquée à ses bornes. L'une des branches comporte un circuit résonnant à la fréquence $f_i$. Une autre branche comporte un dipôle à résistance négative fournissant une onde à la fréquence $f_o$.

Enfin la troisième branche comporte un générateur de fréquence à la fréquence $f_{inj}$, avec $f_i \simeq f_o - f_{inj}$.

La présente invention concerne un oscillateur pour hyperfréquence stabilisé à conversion de fréquence comprenant trois branches $f_s$, $f_o$, $f_p$ montées en parallèle sur une réactance non linéaire C(V) dont la valeur dépend de la tension appliquée à ses bornes, l'une des branches comportant un circuit résonnant à la fréquence $f_o$, une autre branche comportant un dipôle (D) à résistance négative fournissant une onde de pompe à la fréquence $f_p$ et la troisième branche fonctionnant à la fréquence $f_s$ telle que $f_o = f_p - f_s$, caractérisé en ce que la troisième branche comporte un circuit résonnant à ladite fréquence $f_s$, et en ce que, pour la production d'une onde de fréquence $f_o$, les deux conditions d'impédance suivantes sont réalisées :

$$1.\ Z_c(f_p) + R_p + JX_p = 0$$

où $Z_c(f_p)$ représente l'impédance de la réactance non linéaire C(V) à la fréquence de pompe $f_p$, compte-tenu des impédances des autres dérivations, et où $R_p + JX_p$ représente l'impédance de la branche de fréquence $f_p$ ;

$$2.\ Z_c(f_s) + Z_s = 0$$

où $Z_c(f_s)$ représente l'impédance de la réactance non linéaire C(V) à la fréquence $f_s$, pour qu'une oscillation s'établisse à la fréquence $f_s$ et où $Z_s$ représente l'impédance de la branche à la fréquence $f_s$.

L'invention sera mieux comprise en ce reportant à la description qui suit et aux figures jointes qui représentent :

figure 1, le schéma d'un amplificateur paramétrique tel que connu de l'art ;

figure 2, le schéma d'un oscillateur stabilisé de l'invention ;

figure 3, un autre schéma relatif au même oscillateur ;

figures 4 et 5, deux variantes de réalisation à l'état solide de l'oscillateur de la figure 3.

La figure 1 donne le schéma d'un amplificateur paramétrique, connu de l'art.

Une source appelée pompe fournit une tension de grande amplitude de fréquence $f_p$ aux bornes de la capacité C(V), dont la valeur dépend de la tension qui est appliquée entre ses armatures. Un signal incident, à la fréquence $f_s$, est fourni par un générateur $V_s$ monté à l'entrée de l'une des voies, 1 d'un

circulateur A, dont les deux autres voies débouchent l'une, repère 2, sur la capacité (C(V) précédente, et l'autre, repère 3, sur une résistance de charge $R_s$. En fonctionnement, l'onde à la fréquence $f_s$ emprunte la voie 2 vers la capacité C(V), flèche coudée inférieure ; elle est amplifiée par réflexion vers la voie 3 qu'elle emprunte au retour, flèche coudée supérieure, vers la résistance de charge $R_s$. En même temps, dans une troisième dérivation, est engendré un signal à la fréquence $f_o$ reliée aux fréquences précédentes $f_p$ et $f_s$ comme déjà indiqué. La fréquence $f_p$ est couramment dans un amplificateur paramétrique de plusieurs fois à plusieurs dizaines de fois, la fréquence $f_s$ ; le gain en puissance est couramment de l'ordre de 10 à 15 décibels.

Sur la figure R, $R_o$ et $R_p$ désignent, respectivement, la résistance de perte série de la capacité C(V) et des dérivations aux fréquences $f_o$ et $f_p$ ; les rectangles représentent des filtres passe-bandes aux différentes fréquences.

Dans un amplificateur paramétrique, la puissance disponible sur la fréquence $f_o$ reste inutilisée.

Le même dispositif peut servir à engendrer de la puissance haute fréquence utilisée sur la fréquence $f_o$. Pour cela, certaines conditions d'impédance doivent être réalisées.

En supposant que $Z_c(f_p)$ représente l'impédance de la capacité non linéaire C(V) à la fréquence de pompe $f_p$, compte tenu des impédances des deux autres dérivations, et $jX_p + R_p$ l'impédance de la branche de fréquence $f_p$, on doit avoir

$$Z_c(f_p) + R_p + jX_p = 0. \qquad (I)$$

De même, si $Z_c(f_s)$ désigne l'impédance de la capacité C(V) à la fréquence $f_s$, pour qu'une oscillation s'établisse à la fréquence $f_s$, on doit avoir entre l'impédance $Z_s$ de la branche à la fréquence $f_s$ et l'impédance $Z_c(f_s)$ précédente la relation

$$Z_s + Z_c(f_s) = 0. \qquad (II)$$

Si ces deux conditions sont satisfaites, une puissance est disponible sur la fréquence $f_o$, créée par combinaison des fréquences $f_s$ et $f_p$, qui peut être extraite dans une charge d'utilisation appartenant à un circuit résonant, monté dans la branche à la fréquence $f_o$ et accordé sur cette fréquence ; $Z_o$ représente l'impédance de cette charge.

Dans l'oscillateur de l'invention, ces conditions sont réalisées. En outre, le générateur de la fréquence de pompe $f_p$ est un élément dipôle à résistance négative.

Le schéma en est donné sur la figure 2, où l'on retrouve, avec les mêmes notations, les dérivations de la figure précédente, à cela près que les éléments de la dérivation de pompe sont affectés ici de l'indice D au lieu de l'indice p, comme ils le seront dans la suite, pour rappeler que le générateur de pompe est un dipôle D à résistance négative $-R_D$ ; on a : $-R_D = R_p$. On voit sur ce schéma, d'une part, le circuit résonnant d'impédance $Z_o$ dont il a été question plus haut, aux bornes duquel est recueillie la puissance engendrée sur la fréquence $f_o$, et d'autre part, dans la dérivation $f_s$, un second circuit résonant. Ce circuit est le circuit à grande surtension, sur la fréquence $f_s$, dont il a été question plus haut. Les circuits résonants portent les références $C_o$ et $C_S$.

Il apparaît ainsi que, dans l'oscillateur de l'invention, le dipôle à résistance négative se trouve intégré au dispositif et ses conditions de fonctionnement déterminées par l'ensemble des paramètres des trois dérivations ; le gain notamment, dans la branche $f_s$, est suffisamment élevé pour assurer l'oscillation du système.

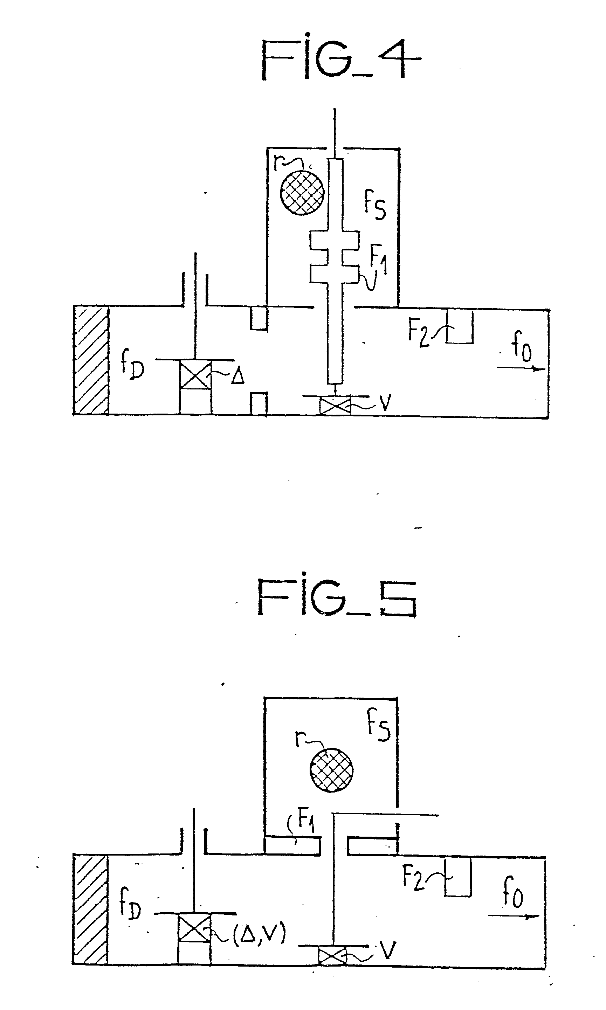

Ces conditions d'oscillation font l'objet de la figure 3, dans laquelle sont précisées les impédances (Z), les courants (I) et les puissances (P) dans chacune des branches refermées sur la capacité. La flèche qui accompagne chaque impédance, dirigée vers la capacité C(V) indique la valeur de cette impédance telle qu'elle est vue par la capacité C(V).

Les signes dont sont affectées les puissances indiquent s'il y a consommation de puissance ou génération dans le circuit correspondant.

On voit sur cette figure que, dans l'oscillateur de l'invention, il y a génération de puissance dans les deux dérivations aux fréquences $f_o$ et $f_s$. Cela signifie que le système permet d'engendrer une puissance haute fréquence aussi bien dans l'une que dans l'autre des dérivations autres que la dérivation à la fréquence de pompe. Cependant c'est celle sur la fréquence $f_o$, la plus élevée, qui est recherchée dans l'invention ; comme on l'a dit, la stabilisation sur cette fréquence est possible par le moyen d'un circuit à plus basse fréquence, et de meilleure qualité, à savoir celui de la branche $f_s$.

On notera d'ailleurs que c'est sur la branche $f_s$ que le bruit est le plus faible.

Deux exemples de séries de valeurs de fréquences réalisables avec le dispositif de l'invention sont :

$$f_s = 10\ \text{GHz} \quad f_D = 45\ \text{GHz} \quad f_o = 35\ \text{GHz} \qquad (1)$$

$$f_s = 300\ \text{MHz} \quad f_D = 6\ \text{GHz} \quad f_o = 5{,}7\ \text{GHz} \qquad (2)$$

la première avec un résonateur diélectrique, la seconde avec un résonateur à ondes élastiques de surface sur $f_s$. On voit que la fréquence $f_o$ peut être de l'ordre de 20 fois la fréquence $f_s$.

La puissance $p_D$, fournie à la capacité C(V) par la source de pompe, se partage entre les deux autres dérivations suivant la relation :

$$P_s/f_s = P_D/f_D = P_o/f_o$$

dans le cas d'une capacité C(V) sans pertes (R = 0 avec les notations précédentes). On voit, sur cette expression, que la plus grande partie de la puissance fournie par la source de pompe est recueillie sur la fréquence $f_o$.

Cette relation se trouve modifiée dans le cas réel avec pertes.

Dans ce cas, dès que la puissance de la source de pompe dépasse la valeur nécessaire pour que l'oscillation apparaisse sur les fréquences $f_s$ et $f_o$, la dérivation de pompe est équivalente à un circuit dont le coefficient de qualité, ou surtension, est du même ordre que celui du circuit à basse fréquence $f_s$, quel que soit le rapport $f_D/f_S$, c'est-à-dire même pour des fréquences de pompe très éloignées de la fréquence $f_s$.

Les conditions à respecter pour obtenir le niveau nécessaire dans le circuit de pompe, c'est-à-dire les conditions de charge du dipôle à résistance négative, sont analogues à celles à réaliser pour un dipôle monté sur une branche unique, avec une fréquence unique de fonctionnement.

L'oscillateur de l'invention trouve une de ses applications dans les installations de réception radioélectrique, radar notamment, comme source locale.

On a raisonné dans ce qui précède sur une capacité non linéaire ou paramétrique C(V). Les mêmes résultats peuvent être obtenus de façon plus générale avec une réactance non linéaire.

On notera enfin que, à fréquence $f_s$ donnée, la fréquence $f_o$ peut être accordée par variation de la réactance $X_D$ du dipôle à résistance négative de pompe ($X_p$ dans l'équation (I)), sans aucune modification corrélative du coefficient de qualité du circuit à fréquence $f_s$.

Le dispositif de l'invention est susceptible de réalisations à partir de composants à l'état solide. Deux exemples en sont donnés ci-dessous. Le circuit résonant à haute surtension à la fréquence $f_s$ est alors un résonateur diélectrique, la source de pompe une diode Gunn ou à avalanche. Quant à l'élément non linéaire, il consiste, dans le cas d'une capacité, en une diode à l'état solide à capacité variable, consistant en une diode polarisée en inverse par une tension continue réglable qui fixe l'étendue de sa zone désertée. Les trois dérivations $f_s$, $f_o$ et $f_D$ sont constituées de trois tronçons de guide d'ondes des types utilisés dans la technique des micro-ondes.

Dans l'exemple de réalisation de la figure 4, le résonateur diélectrique est désigné par la lettre r, la diode à capacité variable par la lettre V et la diode à résistance négative par la lettreΔ, diode Gunn dans l'exemple. Le montage des éléments dans les tronçons de guide d'ondes a lieu suivant la pratique connue en cette matière. Les guides d'ondes, à section rectangulaire, sont représentés en coupe par le plan médian parallèle à leurs petits côtés. $F_1$ et $F_2$ désignent respectivement un filtre coupe-bande et un filtre passe-bande ; le rectangle hachuré est un court-circuit qui ferme le guide horizontal à l'une de ses extrémités, dont l'autre débite sur l'impédance de charge non représentée, $Z_o$ à la fréquence $f_o$, dans les conditions d'adaptation habituelles. Le guide est à la coupure par la fréquence $f_D$ dans sa partie à droite de $F_2$. Dans une variante à la disposition précédente représentée sur la figure 5, la diode, à avalanche, joue à la fois le rôle de source à la fréquence de pompe et d'inductance paramétrique. Dans ce cas, la diode à capacité variable V sert simplement à l'accord électronique en fréquence.

Elle peut être supprimée ; on lui a conservé le même repère V.

Les résonateurs r sont des cylindres, en l'un des matériaux utilisés habituellement à cette fin.

Les sources de tension, dont le montage dans le dispositif relève de l'art connu, n'ont pas été représentées sur les dessins.

**Revendications**

1. Oscillateur pour hyperfréquence stabilisé à conversion de fréquence comprenant trois branches ($f_s$, $f_o$, $f_p$) montées en parallèle sur une réactance non linéaire C(V) dont la valeur dépend de la tension appliquée à ses bornes, l'une des branches comportant un circuit résonnant à la fréquence $f_o$, une autre branche comportant un dipôle (D) à résistance négative fournissant une onde de pompe à la fréquence $f_p$ et la troisième branche fonctionnant à la fréquence $f_s$ telle que $f_o = f_p - f_S$, caractérisé en ce que la troisième branche comporte un circuit résonnant à ladite fréquence $f_s$, et en ce que pour les productions d'une onde sur la fréquence $f_o$, les deux conditions d'impédance suivantes sont réalisées :

$$1.\ Z_c(f_p) + R_p + JX_p = 0$$

où $Z_c(f_p)$ représente l'impédance de la réactance non linéaire C(V) à la fréquence de pompe $f_p$, compte-tenu des impédances des autres dérivations, et où $R_p + JX_p$ représente l'impédance de la branche de fréquence $f_p$ ;

$$2.\ Z_c(f_s) + Z_s = 0$$

où $Z_c(f_s)$ représente l'impédance de la réactance non linéaire C(V) à la fréquence $f_s$, pour qu'une oscillation s'établisse à la fréquence $f_s$ et où $Z_s$ représente l'impédance de la branche à la fréquence $f_s$.

2. Oscillateur pour hyperfréquences suivant la revendication 1, caractérisé en ce que la réactance non linéaire est constituée par la capacité d'une diode à l'état solide (V) polarisée en inverse par une tension réglable, et en ce que le dipôle consiste également en une diode à l'état solide (Δ), à résistance négative.

3. Oscillateur pour hyperfréquences suivant la revendication 2, caractérisé en ce que ces deux diodes (Δ) et (V) sont distinctes.

4. Oscillateur pour hyperfréquences suivant la revendication 2, caractérisé en ce que ces deux diodes sont confondues en une seule (Δ, V).

5. Oscillateur pour hyperfréquences suivant la revendication 3, caractérisé en ce que les deux diodes (Δ) et (V) sont montées dans le plan médian d'un tronçon de guide d'ondes à section rectangulaire parallèle à ses petits côtés, ce tronçon étant fermé, à l'une de ses extrémités, sur un court-circuit (hachures sans repère) et à l'autre, sur la charge dans laquelle est recueillie l'onde à la fréquence $f_o$, ce tronçon formant un T avec un autre tronçon de guide d'ondes rectangulaire, auquel il est raccordé par son grand côté et dans lequel est placé le circuit résonant (r) à la fréquence $f_s$.

6. Oscillateur pour hyperfréquences suivant la revendication 5, caractérisé en ce que le circuit résonant (r) sur la fréquence $f_s$ est un résonateur diélectrique.

7. Oscillateur pour hyperfréquences suivant la revendication 4, caractérisé en ce que la diode à résistance négative et à réactance non linéaire (Δ, V) est montée dans le plan médian d'un tronçon de guide d'ondes à section rectangulaire parallèle à ses petits côtés, ce tronçon étant fermé, à l'une de ses extrémités, sur un court-circuit (hachures sans repères) et à l'autre, sur la charge dans laquelle est recueillie l'onde à la fréquence $f_o$, ce tronçon formant un T avec un autre tronçon de guide d'ondes rectangulaire, auquel il est raccordé par son grand côté et dans lequel est placé le circuit résonant (r) à la fréquence $f_s$.

8. Oscillateur pour hyperfréquences selon l'une des revendications 1 à 7, caractérisé en ce que chacune des trois branches $f_s$, $f_o$ et $f_p$ comporté un filtre passe-bande respectivement à la fréquence $f_s$, $f_o$ et $f_p$.

**Claims**

1. A stabilized microwave oscillator with frequency conversion, comprising three branches ($f_s$ ; $f_o$ ; $f_p$) which are parallelly connected to a non-linear impedance C(V) whose value depends on the voltage applied to its terminals, one of the branches containing a circuit which oscillates at the frequency $f_o$, another branch containing a dipole (D) having a negative resistance and furnishing a pumping wave at the frequency $f_p$, and the third branch being operated at the frequency $f_s$ in such a way that $f_o = f_p - f_s$, characterized in that the third branch contains a circuit oscillating at said frequency $f_s$ and that, in view of the generation of a wave having the frequency $f_o$, the two following impedance conditions are met:

$$1.\ Z_c(f_p) + R_p + JX_p = 0$$

in which $Z_c(f_p)$ represents the value of the non-linear impedance C(V) at the pumping frequency $f_p$, taking into account the impedances of the other branches, and in which $R_p + JX_p$ represents the impedance of the branch operating at the frequency $f_p$ ;

$$2.\ Z_c(f_s) + Z_s = 0$$

in which $Z_c(f_s)$ represents the value of the non-linear impedance C(V) at the frequency $f_s$ such that an oscillation at the frequency $f_s$ in established, and in which $Z_s$ represents the impedance of the branch operating at the frequency $f_s$.

2. An oscillator for microwaves according to claim 1, characterized in that the non-linear impedance is constituted by the capacitance of a solid state diode (V) which is inversely biased by a controllable voltage, and that the dipole also consists of a solid state diode (Δ) having a negative resistance.

3. An oscillator for microwaves according to claim 2, characterized in that the two diodes (Δ) and (V) are distinct diodes.

4. An oscillator for microwaves according to claim 2, characterized in that the two diodes are merged in a unique diode (Δ, V).

5. An oscillator for microwaves according to claim 3, characterized in that the two diodes (Δ) and (V) are mounted in the middle plane of a rectangular waveguide section, the plane being parallel to its small sides, the section being closed at one of its ends on a short-circuit (hatching without reference) and at the other end on the load in which the wave at the frequency $f_o$ is available, this section being arranged in a T structure with another rectangular waveguide section to which it is connected via its large side and in which the circuit (r) oscillating at the frequency $f_s$ is located.

6. An oscillator for microwaves according to claim 5, characterized in that the circuit (r) oscillating at the frequency $f_s$ is a dielectric resonator.

7. An oscillator for microwaves according to claim 4, characterized in that the diode having a negative resistance and a non-linear impedance (Δ, V) is mounted in the middle plane of a rectangular waveguide section, this plane being parallel to its small sides, this section being closed at one of its ends on a short circuit (hatching without references) and at the other end on the load in which the wave at the frequency $f_o$ is available, this section being arranged in a T structure with another rectangular waveguide section, to which it is connected via its large side and in which the circuit (r) oscillating at the frequency $f_s$ is located.

8. An oscillator for microwaves according to one of the claims 1 to 7, characterized in that each one of the three branches ($f_s$, $f_o$ and $f_p$) includes a band-pass filter centered respectively on the frequency $f_s$, $f_o$ and $f_p$.

**Patentansprüche**

1. Stabilisierter Mikrowellenoszillator mit Frequenzumsetzung, mit drei zu einer nichtlinearen Impedanz C(V), deren Wert von der an ihre Klemmen angelegten Spannung abhängt, parallelen Zweigen ($f_s : f_o ; f_p$), von denen einer einen bei der Frequenz $f_o$ schwingenden Kreis enthält, ein zweiter einen Dipol (D) mit negativem Widerstand aufweist, der eine Pumpwelle der Frequenz $f_p$ liefert, und der dritte Zweig bei der Frequenz $f_s$ betrieben wird, wobei gilt $f_o = f_p - f_s$, dadurch gekennzeichnet, daß der dritte Zweig einen bei der Frequenz $f_s$ schwingenden Resonanzkreis enthält und daß für die Erzeugung einer Welle mit der Frequenz $f_o$ die beiden folgenden Impedanzbedingungen erfüllt sind :

$$1.\ Z_c(f_p) + R_p + JX_p = 0$$

wobei $Z_c(f_p)$ den Wert der nichtlinearen Impedanz C(V) bei der Pumpfrequenz $f_p$ unter Berücksichtigung der Impedanzen der anderen Ableitungen und $R_p + Jx_p$ den Impedanzwert des Zweigs mit der Frequenz $f_p$ bildet ;

$$2.\ Z_c(f_s) + Z_s = 0$$

wobei $Z_c(f_s)$ den Wert der nichtlinearen Impedanz C(V) bei der Frequenz $f_s$ darstellt, bei der sich eine Schwingungen der Frequenz $f_s$ ausbildet, und wobei $Z_s$ die Impedanz des bei der Frequenz $f_s$ betriebenen Zweiges bildet.

2. Oszillator für Mikrowellen nach Anspruch 1, dadurch gekennzeichnet, daß die nichtlineare Impedanz von der Kapazität einer mit einer regelbaren Spannung invers vorgespannten Festkörperdiode (V) gebildet wird und daß der Dipol ebenfalls aus einer Festkörperdiode (Δ), und zwar mit negativem Widerstand, gebildet wird.

3. Oszillator für Mikrowellen nach Anspruch 2, dadurch gekennzeichnet, daß es sich bei den beiden Dioden (Δ) und (V) um getrennte Dioden handelt.

4. Oszillator für Mikrowellen nach Anspruch 2, dadurch gekennzeichnet, daß die beiden Dioden (Δ, V) zu einer einzigen Diode vereint sind.

5. Oszillator für Mikrowellen nach Anspruch 3, dadurch gekennzeichnet, daß die beiden Dioden (Δ) und (V) in der Mittelebene eines Abschnitts eines Rechteckwellenleiters montiert sind, die parallel zu den kleinen Seiten des Wellenleiters verläuft, wobei dieser Abschnitt an einem seiner Enden über einen Kurzschluß (Schraffierung ohne Bezugszeichen) abgeschlossen ist, während am anderen Ende die Last liegt, an der die Welle mit der Frequenz $f_o$ abgegriffen wird, und wobei dieser Abschnitt ein T mit einem anderen Rechteckwellenleiterabschnitt bildet, an den er über seine große Seite angeschlossen ist und in dem der bei der Frequenz $f_s$ schwingende Resonanzkreis (r) liegt.

6. Oszillator für Mikrowellen nach Anspruch 5, dadurch gekennzeichnet, daß der bei der Frequenz $f_s$ schwingende Resonanzkreis (r) ein dielektrischer Resonator ist.

7. Oszillator für Mikrowellen nach Anspruch 4, dadurch gekennzeichnet, daß die Diode mit negativem Widerstand und nicht-linearer Impedanz (Δ, V) in der Mittelebene eines Rechteckwellenleiterabschnitts, die parallel zu den kleinen Wellenleiterseiten verläuft, montiert ist, wobei dieser Abschnitt an einem seiner Enden über einen Kurzschluk (Schraffierung ohne Bezugszeichen) und am anderen Ende über die Last abgeschlossen ist, in der die Welle mit der Frequenz $f_o$ abgegriffen wird, und wobei dieser Abschnitt ein T mit einem anderen Rechteckwellenleiterabschnitt bildet, an den er über seine große Seite angeschlossen ist und in dem der bei der Frequenz $f_s$ schwingende Resonanzkreis (r) angeordnet ist.

8. Oszillator für Mikrowellen nach einem der Ansprüche 1 bis 7, dadurch gekennzeichnet, daß jeder der drei Zweige $f_s$, $f_o$ und $f_p$ ein Bandpassfilter enthält, das auf die Frequenz $f_s$ bzw. $f_o$ bzw. $f_p$ zentriert ist.

FIG_1

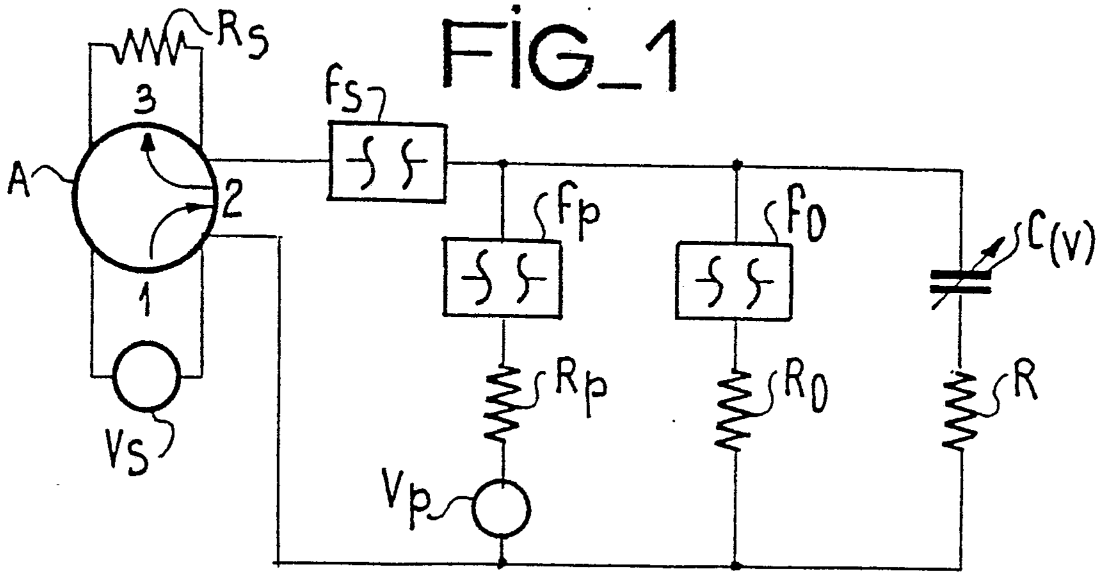


FIG_2

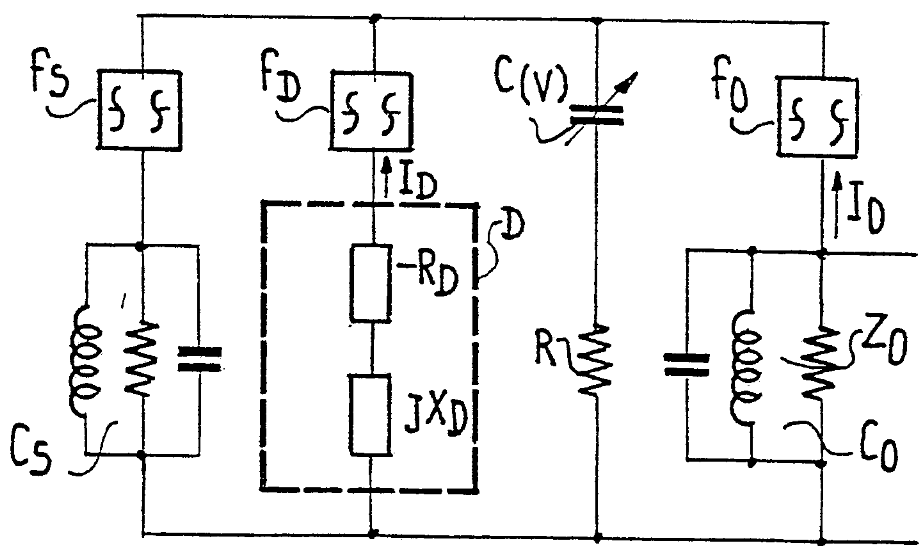


FIG_3

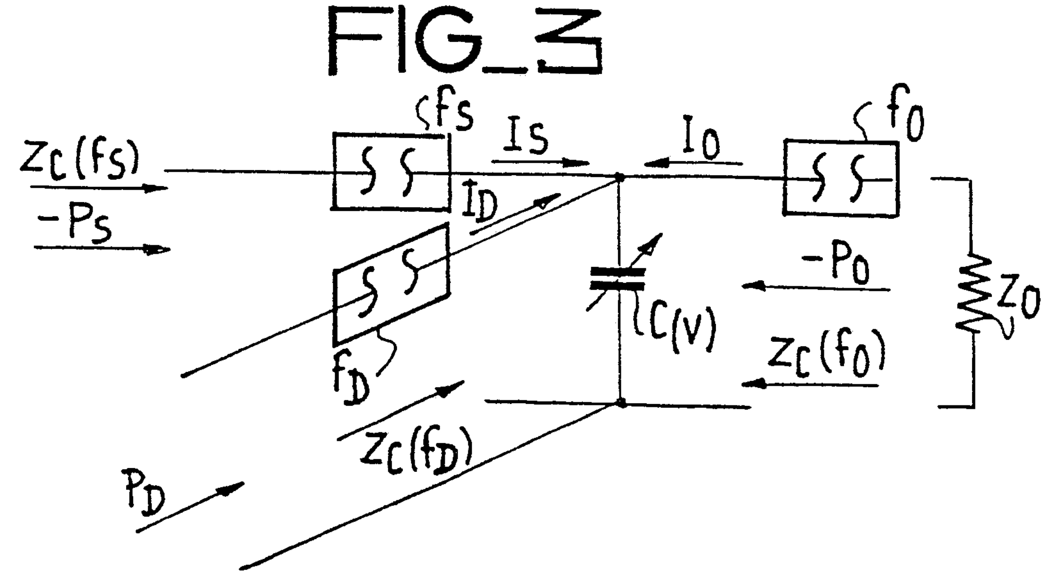

FIG_4

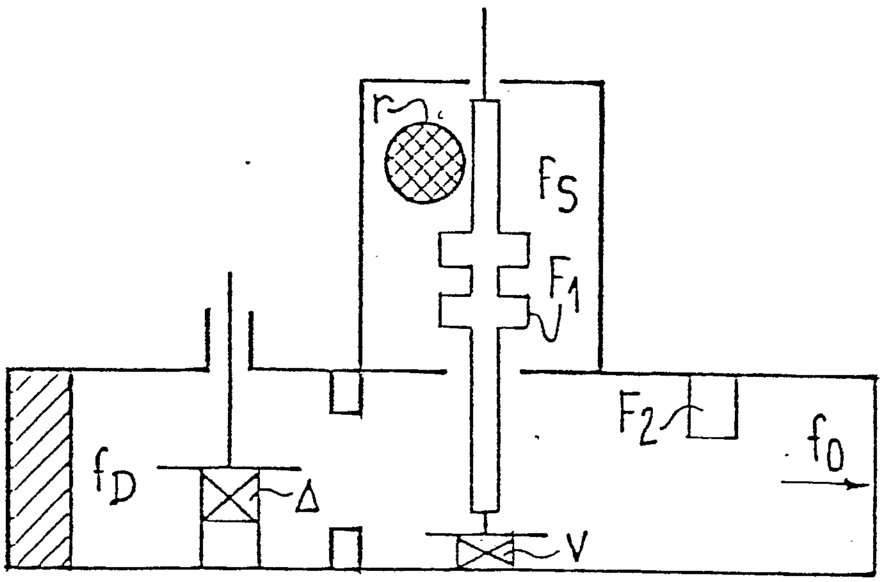


FIG_5